(19) Europäisches Patentamt
European Patent Office
Office européen des brevets

(11) **EP 3 405 007 A1**

(12) **EUROPEAN PATENT APPLICATION**

(43) Date of publication:
**21.11.2018 Bulletin 2018/47**

(51) Int Cl.:
**H05B 33/08** (2006.01)  **F21V 23/06** (2006.01)
**H01L 51/52** (2006.01)  **H01L 27/32** (2006.01)

(21) Application number: **18172713.2**

(22) Date of filing: **16.05.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.05.2017 TW 106116300**

(71) Applicant: **Industrial Technology Research Institute**
**31040 Hsinchu (TW)**

(72) Inventors:
• LIN, Hsuan-Yu
  **Changhua City, Changhua County 500 (TW)**
• TSAI, Chen-Yen
  **Keelung City 205 (TW)**

(74) Representative: **Emde, Eric**
**Wagner & Geyer**
**Gewürzmühlstrasse 5**
**80538 München (DE)**

(54) **LIGHT EMITTING ELEMENT, DRIVING MODULE FOR LIGHT EMITTING ELEMENT**

(57)    A driving module (200) for driving at least a light emitting element (100) is provided. The driving module includes a driving interface (210) and a multi-channel driver (220). The driving interface is electrically connected to the light emitting element, and the driving interface includes multiple electric channels (212), wherein the electrical channels are selectively to be in a floating state or a connecting state. The multi-channel driver is electrically connected to the driving interface and transmits a constant current signal ($I_1$+PWM, $I_2$+PWM, $I_3$+PWM) to the driving interface, wherein the constant current signal enters the light emitting element through the electrical channels in the connecting state. And, the total current value output by the driving interface is positively correlated with the area of the light emitting element which is as load. Further, a driving method utilizing the driving module is also provided.

FIG. 1A

**Description**

**BACKGROUND**

Technical Field

The disclosure relates to a driving module, and more particularly, to a driving module for a light emitting element.

Description of Related Art

Comparing to conventional light sources such as incandescent lamps, fluorescent lamps, and the like, since organic light emitting diode light source (referred to as the OLED light source hereinafter) is deemed as the new light sources with highly-potential perspective, considering its advantages of thin and light, mercury-free, ultraviolet radiation free, flexible and usable as a planar light source.

At present, the OLED light sources manufactured by various manufacturers have differences in terms of efficiency, area size and structure. Thus, the OLED light sources have a wide range of values for a driving current, and require use a variety of different driving designs for driving. Also, electrode design for the OLED light source has many different forms but there is no uniform electrical connection interface. Furthermore, when multiple different OLED light sources are electrically connected, problems including difficulties in identifying the OLED light source, difficulties in soldering and complexity in electrode structure design will arise.

In general, the different OLED light sources are driven by different driving voltage and current, and the driving current is input through two electrical connectors (a cathode and an anode) of the LED light source. When the OLED light source is short-circuited, a resistance of the OLED light source in short-circuit state also differs (and shows different voltage values too). Conventionally, to solve the problem in identifying the different OLED light sources, a technique involving "adding a set resistor (Rset, for determining the driving current) on the OLED light source, adding a window resistor (Rwindow, for determining a detection voltage in a failure mode) on the OLED light source, and using a five-wiring wire to connect the OLED light source and a driver together" is adopted. However, because such technique requires the set resistor (Rset), the window resistor (Rwindow) and the five-wiring wire disposed in advance on the OLED light source, the overall circuit design is more complicated.

In addition, when multiple OLED light sources are serially connected and driven, in order to meet a voltage upper limit, a number of each OLED light source cascade is necessarily set to 2 to 6 while the driver has only two channels, thus there are utilizing restrictions. Furthermore, when the value of the driving current is changed by utilizing a manual switch so the driving current can be provided to the OLED light sources of different types, there are only 4 options which fall within 100mA to 300mA, i.e., an adjustable range of the driving current is narrower. Moreover, since there is no way of knowing a status of the OLED light source, whether or not the OLED light source is short-circuited cannot be determine and thus a short-circuit protection cannot be performed.

**SUMMARY**

The disclosure provides a driving module capable of self-adaptively controlling an output of a driving current according to a light emitting element so as to perform appropriate driving and short-circuit protection for a variety of different light emitting elements.

The disclosure proposes a driving module for driving at least one light emitting element. The driving module includes a driving interface and a multi-channel driver. The driving interface is electrically connected to the light emitting element, and the driving interface has a plurality of electrical channels. Here, the electrical channels are selectively to be in a floating state or a connecting state. The multi-channel driver is electrically connected to the driving interface, and the multi-channel driver transmits a constant current signal to the driving interface. Here, the constant current signal enters the light emitting element through the electrical channel in the connecting state, and a total current value output by the driving interface is positively correlated with an area size of the light emitting element being a load.

The disclosure proposes a driving module for driving at least one light emitting element. The driving module includes a driving interface and a multi-channel driver. The driving interface is electrically connected to the light emitting element, and the driving interface has a plurality of electrical channels. Here, the electrical channels are selectively to be in a floating state or a connecting state. The multi-channel driver is electrically connected to the driving interface, and the multi-channel driver transmits a constant current signal to the driving interface. Here, the constant current signal enters the light emitting element through the electrical channel in the connecting state, and a total current value output by the driving interface is negatively correlated with an efficiency of the light emitting element being a load.

The disclosure further proposes a light emitting element which includes a driving interface. The driving interface has a plurality of electrical channels, wherein the electrical channels are selectively to be in a floating state or a connecting state according to an area size or an efficiency level of the light emitting element.

Based on the above, the driving module and the driving method of the disclosure are capable of automatically providing the driving current corresponding to various light emitting elements in different specifications. As a result, a standardized electrical/mechanical interface design may be provided for a variety of light emitting elements in different specifications, and may be compatible with a variety of lighting modules in different specifications

To make the aforementioned more comprehensible, several embodiments accompanied with drawings are described in detail as follows.

**BRIEF DESCRIPTION OF THE DRAWINGS**

The accompanying drawings are included to provide a further understanding of the disclosure, and are incorporated in and constitute a part of this specification. The drawings illustrate exemplary embodiments of the disclosure and, together with the description, serve to explain the principles of the disclosure.

FIG. 1A is a schematic diagram of a driving module in an embodiment of the disclosure.
FIG. 1B is a schematic diagram of a driving module in another embodiment of the disclosure.
FIG. 2A is a schematic diagram of a constant current signal in an embodiment of the disclosure.
FIG. 2B is a schematic diagram of a constant current signal in another embodiment of the disclosure.
FIG. 3A to FIG. 3C are schematic diagrams respectively illustrating first to third organic light emitting elements driven by a driving module in an embodiment of the disclosure.
FIG. 4A and FIG. 4B are schematic diagrams illustrating organic light emitting elements driven by a driving module adopting a common anode structure in an embodiment of the disclosure.
FIG. 5A and FIG. 5B are schematic diagrams illustrating organic light emitting elements driven by a driving module adopting a common cathode structure in an embodiment of the disclosure.
FIG. 6A to FIG. 6C are schematic diagrams respectively illustrating electrical connectors of a driving interface for driving first to third organic light emitting elements in an embodiment of the disclosure.
FIG. 7A and FIG. 7B are schematic diagrams illustrating electrical connectors of a driving interface adopting a common cathode structure in an embodiment of the disclosure.
FIG. 7C and FIG. 7D are schematic diagrams illustrating electrical connectors of a driving interface adopting a multi-cathode structure in another embodiment of the disclosure.
FIG. 8A and FIG. 8B are schematic diagrams illustrating electrical connectors of a driving interface adopting a common anode structure in an embodiment of the disclosure.
FIG. 8C and FIG. 8D are schematic diagrams illustrating electrical connectors of a driving interface adopting a multi-anode structure in another embodiment of the disclosure.
FIG. 9A is an equivalent circuit diagram of an organic light emitting element in an embodiment of the disclosure.
FIG. 9B is an equivalent circuit diagram of an organic light emitting element in short-circuit state in an embodiment of the disclosure.
FIG. 10A to FIG. 10C are schematic diagrams respectively illustrating first to third organic light emitting elements in short-circuit state driven by a driving module in an embodiment of the disclosure.

**DESCRIPTION OF THE EMBODIMENTS**

The driving module and the driving method of the disclosure are capable of automatically providing a driving current corresponding to various light emitting elements in different specifications. Said light emitting elements may be organic light emitting elements or inorganic light emitting elements. Here, the inorganic light emitting elements may be light emitting elements containing inorganic quantum dots, such as an electroluminescence quantum dot light emitting element. In the following embodiments, related description is provided with reference to the organic light emitting element as an example.

[Embodiment of driving module]

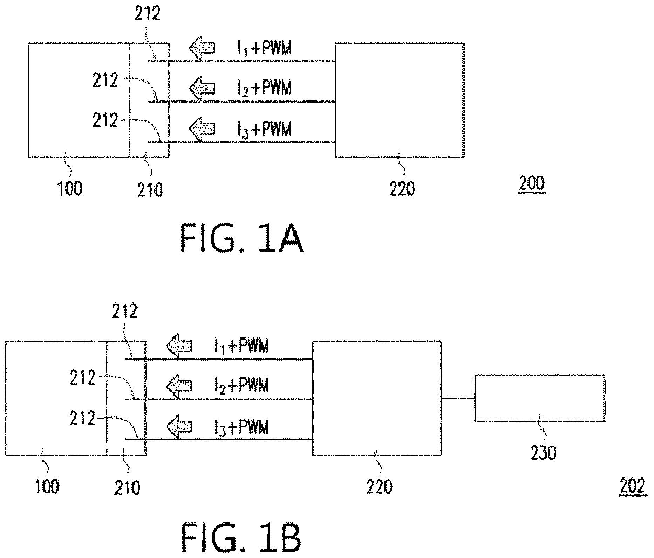

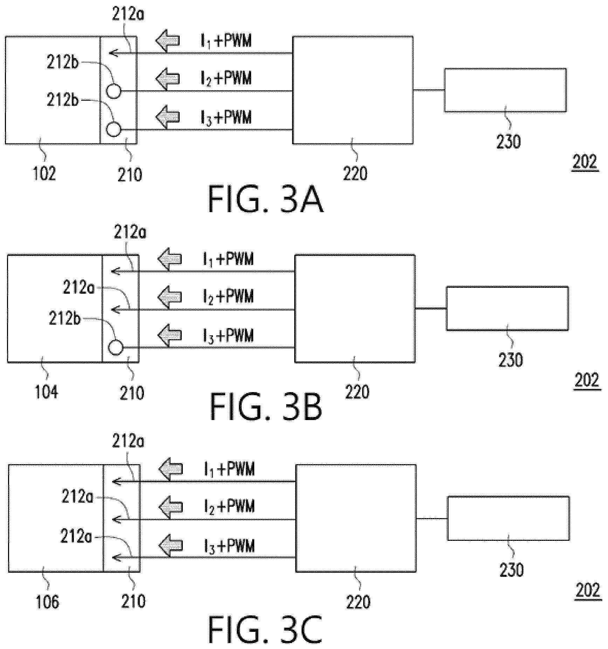

FIG. 1A is a schematic diagram of a driving module in an embodiment of the disclosure. With reference to FIG. 1A, in this embodiment, a driving module 200 may be used to drive at least one organic light emitting element 100. The driving module 200 includes a driving interface 210 and a multi-channel driver 220. The driving interface 210 is electrically connected to the organic light emitting element 100, and the driving interface 210 has a plurality of electrical channels 212. The electrical channels 212 are selectively to be in a floating state or a connecting state (referring to subsequent embodiments of FIG. 3A to FIG. 3C for further description). In detail, the floating state refers to the electrical channel 212 not being electrically turned on, and the connecting state refers to the electrical channel 212 being electrically turned on. The multi-channel driver 220 is electrically connected to the driving interface 210, and the multi-channel driver 220 transmits a constant current signal to the driving interface 210. Here, the constant current signal enters the organic light emitting element 100 through the electrical channels 212 in the connecting state, and a total current value output by the driving interface 210 is positively correlated with an area size of the organic light emitting element 100 being a load.

In the driving module according to one embodiment of the disclosure, the total current value output by the driving interface 210 may be positively correlated with the area size of the organic light emitting element 100 being the load. That is to say, the total current value required is greater if the area size of the organic light emitting element 100 is larger; the total current value required is smaller if the area size of the organic light emitting element 100 is smaller.

Nonetheless, in another embodiment of the disclosure, the total current value output by the driving interface 210 may be negatively correlated with an efficiency of the organic light emitting element 100 being the load. That is to say, the total current value required is smaller under the same luminous intensity when the efficiency of the organic light emitting element 100 is better; the total current value required is greater under the same luminous intensity when the efficiency of the organic light emitting element 100 is poor. Here, the efficiency of the organic light emitting element 100 relates to a material and a structure of the organic light emitting element 100, and different wavelengths, color temperatures or luminous intensities may be obtained through the choice of the material and the design of the structure.

With reference to FIG. 1A, the multi-channel driver 220 can output the constant current signal to the electrical channels 212 of the driving interface 210. As shown in FIG. 1A, "$I_1$+PWM" may be output to the first electrical channel 212, "$I_2$+PWM" may be output to the second electrical channel 212, and "$I_3$+PWM" may be output to the third electrical channel 212. The following paragraphs will continue to explain possible implementations of the organic light emitting element 100, the driving interface 210 and the multi-channel driver 220, where $I_1$, $I_2$ and $I_3$ may be equal or not equal to each other.

[Embodiment of organic light emitting element]

With reference to FIG. 1A, the organic light emitting element 100 may include a cathode, an anode and an organic light emitting layer, which are not illustrated. The anode is used for inputting electron holes, and the cathode is used for inputting electrons. The electrons and the electron holes combine in the organic light emitting layer to emit light. The organic light emitting element 100 may be manufactured in large area, and has flexibility and cutability.

[Embodiment of driving interface]

With reference to FIG. 1A, the driving interface 210 has a plurality of electrical channels 212. The driving interface 210 may be an independent circuit element (e.g., a printed circuit board (PCB), a flexible printed circuit (FPC) or a polymer thick film (PTF)), and may be electrically connected to the organic light emitting element 100. In addition, the driving interface 210 may also be a peripheral circuit integrated onto the organic light emitting element 100.

[Embodiment of multi-channel driver]

The multi-channel driver 220 may include a plurality of channels (e.g., 16 channels or 24 channels), which may be configured to output a driving current. In this way, a plurality of the organic light emitting elements 100, or a cascade of the organic light emitting elements 100 serially connected to each other may be controlled at one time.

In general, a setting method regarding the driving current of the multi-channel driver 220 may include the following two types: (1) External resistor type, which utilizes an external resistor to make the driving current become a constant current, and is usually seen in a common anode multi-channel driver. This type of multi-channel driver may be implemented by commercially available integrated circuits, such as multi-channel driver with product IDs of TLC 5948 and TLC5952S made by Texas Instruments Inc. (2) Voltage reference type, which makes the driving current in a linear relationship with an adjusting voltage ($V_{ADJ}$), and is commonly in a common cathode multi-channel driver. This type of multi-channel driver may be implemented by commercially available integrated circuits, such as the multi-channel driver with product ID of LT3475 made by Linear Technology Co.

[Another embodiment of driving module]

FIG. 1B is a schematic diagram of a driving module in another embodiment of the disclosure. With reference to FIG. 1B, in this embodiment, a driving module 202 may further include a controller 230, which is electrically connected to the multi-channel driver 220. The controller 230 may further control the constant current signal output by the multi-channel driver 220. In other words, the controller 230 may input a serial signal into the multi-channel driver 220, so as to control a magnitude of an output current for each channel of the multi-channel driver 220.

[Embodiment of constant current signal]

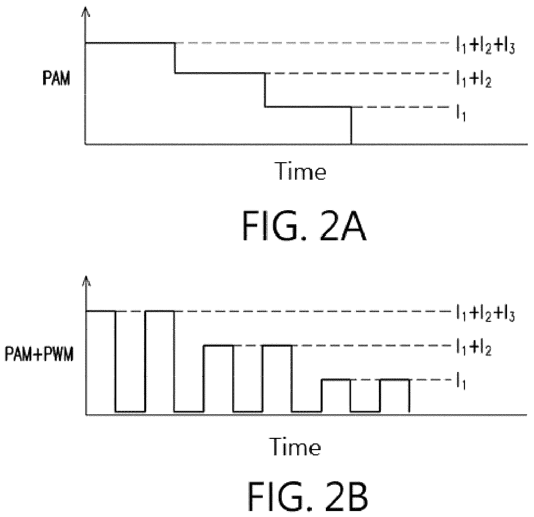

FIG. 2A is a schematic diagram of a constant current signal in an embodiment of the disclosure. Referring to FIG. 1A, FIG. 1B and FIG. 2A together, by designing the floating state or the connecting state on the driving interface according to an area of the organic light emitting element 100, the constant current signal input to the driving interface 210 may be changed accordingly (in positive correlation). The constant current signal may include a plurality of pulse amplitude modulating signals PAM having different sizes and superimposing with each other, i.e., $I_1$, $I_1+I_2$, $I_1+I_2+I_3$.

When the area of the organic light emitting element 100 is small, $I_1$ may be input; when the area of the organic light emitting element 100 is medium, $I_1+I_2$ may be input; when the area of the organic light emitting element 100 is large, $I_1+I_2+I_3$ may be input.

FIG. 2B is a schematic diagram of a constant current signal in another embodiment of the disclosure. With reference to FIG. 2B, in this embodiment, a pulse width modulation signal is further added onto the pulse amplitude modulating signal of FIG. 2A. In other words, as shown in FIG. 2B, the constant current signal includes a plurality of pulse amplitude modulating signals PAM having different sizes and superimposing with each other, and a pulse width modulation signal PWM having a settable duty ratio. A brightness of the organic light emitting element 100 may be adjusted by utilizing settings of the duty ratio. In other words, when the duty ratio is increased, the brightness of the organic light emitting element 100 is increased accordingly; when the duty ratio is decreased, the brightness of the organic light emitting element 100 is decreased accordingly.

[Embodiment of driving module that automatically provides constant current signal for different organic light emitting elements]

FIG. 3A to FIG. 3C are schematic diagrams respectively illustrating first to third organic light emitting elements driven by a driving module in an embodiment of the disclosure. With reference to FIG. 3A, a first organic light emitting element 102 has a small area. When the driving interface 210 is electrically connected to the first organic light emitting element 102, one electrical channel 212a in the connecting state and two electrical channels 212b in the floating state (i.e., open-circuit state) may be observed, as shown in FIG. 3A. The multi-channel driver 220 provides the constant current signal $I_1+PWM$ to the electrical channel 212a in the connecting state, provides the constant current signal $I_2+PWM$ to the electrical channel 212b in the floating state, and provides the constant current signal $I_3+PWM$ to the electrical channel 212b in the floating state. After detecting the electrical channels 212b in the floating state, the multi-channel driver 220 stops providing the constant current signals $I_2+PWM$ and $I_3+PWM$ so that the constant current signal $I_1+PWM$ enters the first organic light emitting element 102 through the electrical channel 212a in the connecting state.

With reference to FIG. 3B, a second organic light emitting element 104 has a medium area. When the driving interface 210 is electrically connected to the second organic light emitting element 104, two electrical channels 212a in the connecting state and one electrical channel 212b in the floating state may be observed, as shown in FIG. 3B. The multi-channel driver 220 provides the constant current signal $I_1+PWM$ to the electrical channel 212a in the connecting state, provides the constant current signal $I_2+PWM$ to the electrical channel 212a in the connecting state, and provides the constant current signal $I_3+PWM$ to the electrical channel 212b in the floating state. After detecting the electrical channel 212b in the floating state, the multi-channel driver 220 stops providing the constant current signal $I_3+PWM$ so that the constant current signals $I_1+PWM$ and $I_2+PWM$ enter the second organic light emitting element 104 through the electrical channel 212a in the connecting state.

With reference to FIG. 3C, a third organic light emitting element 106 has a large area. When the driving interface 210 is electrically connected to the third organic light emitting element 106, three electrical channels 212a in the connecting state may be observed, as shown in FIG. 3C. The multi-channel driver 220 provides the constant current signals $I_1+PWM$, $I_2+PWM$ and $I_3+PWM$ to the electrical channels 212a in the connecting state so that the constant current signals $I_1+PWM$, $I_2+PWM$ and $I_3+PWM$ enter the third organic light emitting element 106 through the electrical channels 212a in the connecting state.

In the embodiments of FIG. 3A to FIG. 3C, the external resistor may be utilized to set a maximum output current value of the multi-channel driver 220 (e.g., $I_1=I_2=I_3=50mA$ may be set). The multi-channel driver 220 may include a plurality of channels (e.g., the three channels as shown in FIG. 3A to FIG. 3C), and each of the channels outputs the same constant current signal.

By utilizing aforesaid driving module 202 of the disclosure, the constant current signal $I_1+PWM$ may be automatically output for the first organic light emitting element 102 having the small area, and the driving current entering the first organic light emitting element 102 is 50mA in this case; the constant current signals $I_1+PWM$ and $I_2+PWM$ may be automatically output for the second organic light emitting element 104 having the medium area, and the driving current entering the second organic light emitting element 104 is 100mA in this case; the constant current signals $I_1+PWM$, $I_2+PWM$ and $I_3+PWM$ may be automatically output for the third organic light emitting element 106 having the large area, and the driving current entering the third organic light emitting element 106 is 150mA in this case. Naturally, the driving module 200 of FIG. 1A may also be adopted as a replacement to the driving module 202 shown in FIG. 3A to FIG. 3C.

[Embodiment of driving module adopting common anode structure]

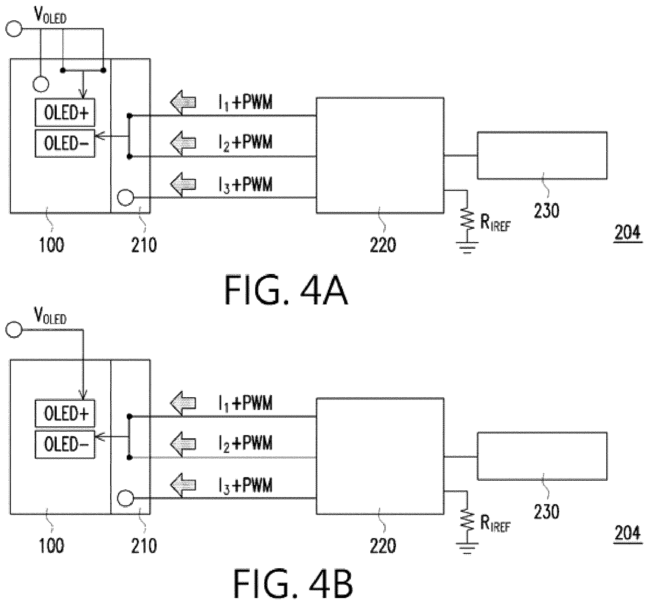

FIG. 4A and FIG. 4B are schematic diagrams illustrating organic light emitting elements driven by a driving module adopting a common anode structure in an embodiment of the disclosure. With reference to FIG. 4A, a driving module 204 may include a reference resistor $R_{IREF}$, which is connected to the multi-channel driver 220. The multi-channel driver 220 utilizes the reference resistor $R_{IREF}$ to set the maximum output current value of the multi-channel driver 220 (e.g., $I_1=I_2=I_3=50mA$ may be set). It can be noted that, in the embodiment of FIG. 4A, the multi-channel driver 220 includes a plurality of channels (e.g., first to third channels), a set number of the channels may be utilized as a group (e.g., by connecting the first channel with the second channel in parallel, where the constant current signals are 50mA+50mA=100mA in this embodiment), and the same constant current signal is output to the channels of that group and enters a cathode OLED- of the organic light emitting element 100. Furthermore, a plurality of the organic light emitting elements 100 may adopt the common anode structure so that a voltage $V_{OLED}$ is input to an anode OLED+ of the organic light emitting element 100 through the common anode structure (two anode wires connected in parallel) as shown in FIG. 4A.

The embodiment of FIG. 4B is similar to the embodiment of FIG. 4A, and thus the identical content is not repeated hereinafter. It can be noted that, a plurality of the organic light emitting elements 100 also adopt the common anode structure so that the voltage $V_{OLED}$ is input to the anode OLED+ of the organic light emitting element 100 through the common anode structure (one common anode wire) as shown in FIG. 4B.

[Embodiment of driving module adopting common cathode structure]

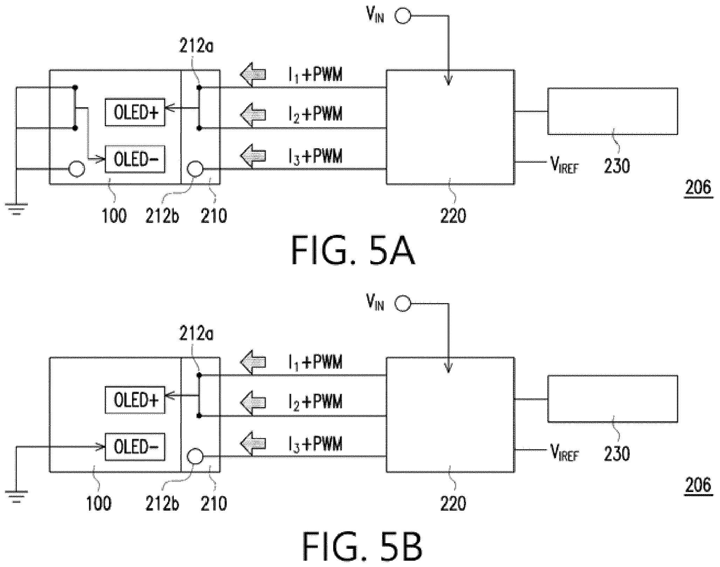

FIG. 5A and FIG. 5B are schematic diagrams illustrating organic light emitting elements driven by a driving module adopting a common cathode structure in an embodiment of the disclosure. With reference to FIG. 5A, in a driving module 206, an input voltage $V_{IN}$ and a reference voltage $V_{IREF}$ are provided to the multi-channel driver 220 to provide the constant current signals. It can be noted that, in the embodiment of FIG. 5A, the multi-channel driver 220 includes a plurality of channels (e.g., first to third channels), a set number of the channels may be utilized as a group (e.g., by connecting the first channel with the second channel in parallel, where the constant current signals are 50mA+50mA=100mA in this embodiment), and the same constant current signal is output to the channels of that group and enters the anode OLED+ of the organic light emitting element 100. Furthermore, a plurality of the organic light emitting elements 100 may adopt the common cathode structure so that the cathode OLED- of the organic light emitting element 100 is connected to the ground through the common cathode structure (two cathode wires connected in parallel) as shown in FIG. 5A.

The embodiment of FIG. 5B is similar to the embodiment of FIG. 5A, and thus the identical content is not repeated hereinafter. It can be noted that, a plurality of the organic light emitting elements 100 also adopt the common cathode structure so that the cathode OLED- of the organic light emitting element 100 is connected to the ground through the common cathode structure (one common cathode wire) as shown in FIG. 5B.

In the common anode structure and the common cathode structure described above, the common anode or the common cathode are manufactured by using a material with high current durability, so as to prevent an overheat phenomenon induced by current; also, by adopting the common anode or the common cathode, a number of the electrical pins used may also be reduced.

[Embodiment of electrode structure of driving interface]

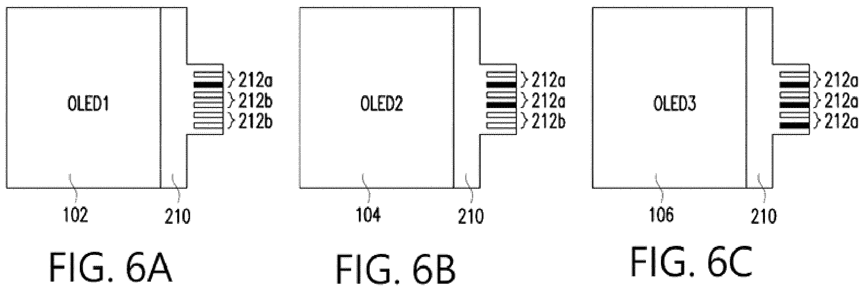

FIG. 6A to FIG. 6C are schematic diagrams respectively illustrating electrical connectors of a driving interface for driving first to third organic light emitting elements in an embodiment of the disclosure. Referring to FIG. 3A and FIG. 6A together, a structure of electrical pins of the driving interface 210 electrically connected to the first organic light emitting element 102 (OLED1) is illustrated. Here, one electrical channel 212a in the connecting state is composed of two electrical pins, and each of two electrical channels 212b in the floating state is composed of two electrical pins.

Referring to FIG. 3B and FIG. 6B together, a structure of electrical pins of the driving interface 210 electrically connected to the second organic light emitting element 104 (OLED2) is illustrated. Here, each of two electrical channels 212a in the connecting state is composed of two electrical pins, and one electrical channel 212b in the floating state is also composed of two electrical pins.

Referring to FIG. 3C and FIG. 6C together, a structure of electrical pins of the driving interface 210 electrically connected to the third organic light emitting element 106 (OLED3) is illustrated. Here, each of three electrical channels 212a in the connecting state is composed of two electrical pins.

[Embodiment of common cathode structure --- single cathode or asymmetrical type]

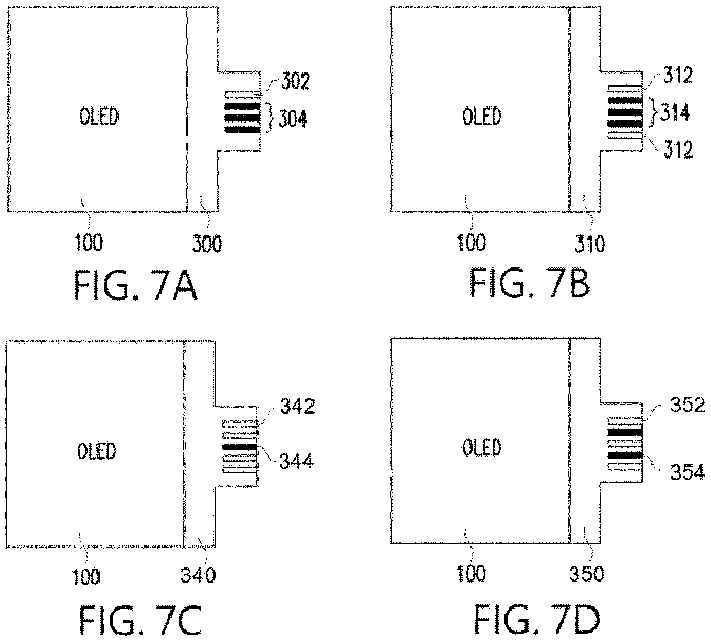

FIG. 7A and FIG. 7B are schematic diagrams illustrating electrical connectors of a driving interface adopting a common cathode structure in an embodiment of the disclosure. With reference to FIG. 7A, a driving interface 300 electrically connected to the organic light emitting element 100 (OLED) adopts the single cathode structure, i.e., in which one cathode 302 and three anodes 304 are disposed. With reference to FIG. 7B, in another embodiment, a driving interface 310 electrically connected to the organic light emitting element 100 (OLED) adopts the asymmetrical type structure, in which two cathodes 312 and three anodes 314 are disposed.

[Embodiment of common cathode structure --- multi-cathode or symmetrical type]

FIG. 7C and FIG. 7D are schematic diagrams illustrating electrical connectors of a driving interface adopting a multi-cathode structure in another embodiment of the disclosure. With reference to FIG. 7C, a driving interface 340 electrically connected to the organic light emitting element 100 (OLED) adopts the multi-cathode structure, i.e., in which a plurality of cathodes 342 and one anode 344 are disposed. With reference to FIG. 7D, in another embodiment, a driving interface 350 electrically connected to the organic light emitting element 100 (OLED) adopts the symmetrical type structure, in which three cathodes 352 and two anodes 354 are disposed.

[Embodiment of common anode structure --- single anode or asymmetrical type]

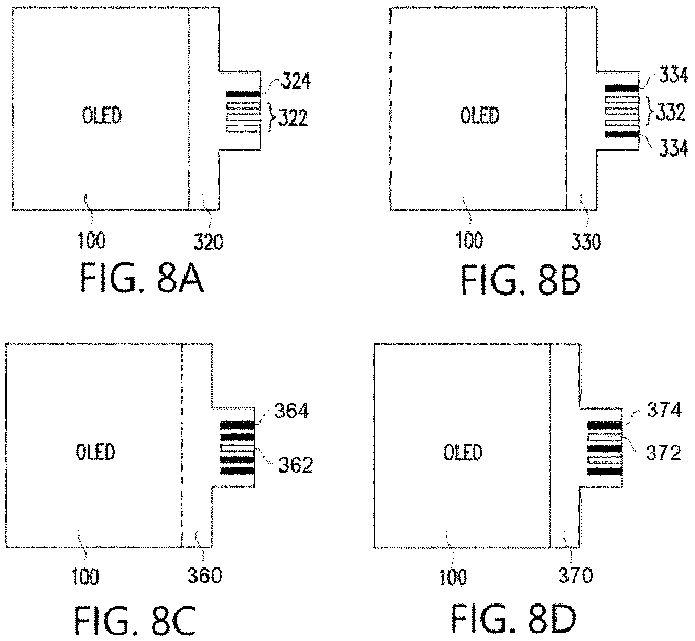

FIG. 8A and FIG. 8B are schematic diagrams illustrating electrical connectors of a driving interface adopting a common anode structure in an embodiment of the disclosure. With reference to FIG. 8A, a driving interface 320 electrically connected to the organic light emitting element 100 (OLED) adopts the single anode structure, i.e., in which one anode 324 and three cathodes 322 are disposed. With reference to FIG. 8B, in another embodiment, a driving interface 330 electrically connected to the organic light emitting element 100 (OLED) adopts the asymmetrical type structure, in which two anodes 334 and three cathodes 332 are disposed.

[Embodiment of common anode structure --- multi-anode or symmetrical type]

FIG. 8C and FIG. 8D are schematic diagrams illustrating electrical connectors of a driving interface adopting a multi-anode structure in another embodiment of the disclosure. With reference to FIG. 8C, a driving interface 360 electrically connected to the organic light emitting element 100 (OLED) adopts the multi-anode structure, i.e., in which four anodes 364 and one cathode 362 are disposed. With reference to FIG. 8D, in another embodiment, a driving interface 370 electrically connected to the organic light emitting element 100 (OLED) adopts the symmetrical type structure, in which three anodes 374 and two cathodes 372 are disposed.

In light of the above, as shown in FIG. 6A to FIG. 6C, two electrical pins may be used to correspond to one electrical channel for good control over the organic light emitting elements 102 to 104; alternatively, as shown in FIG. 7A to FIG. 7B and FIG. 8A to FIG. 8B, one electrical pin (the common cathode or the common anode) may also be used to correspond to multiple electrical channels for reduction on the number of the electrical pins used.

In addition, as shown in FIG. 7C, the electrical channel may contain only one anode channel (i.e., the anode 344); or, as shown in FIG. 8C, the electrical channels may contain only one cathode channel (i.e., the cathode 362). Furthermore, as shown in FIG. 7D, the electrical channels include the cathode channel (i.e., the cathode 352) and the anode channel (i.e., the anode 354), and a distribution of the electrical channels may be a symmetrical distribution. As shown in FIG. 8D, the electrical channels include the cathode channel (i.e., the cathode 372) and the anode channel (i.e., the anode 374), and a distribution of the electrical channels may be a symmetrical distribution. However, the disclosure is not limited by the drawings, and the channels may also be in an asymmetrical distribution.

[Embodiment of equivalent circuit of organic light emitting element]

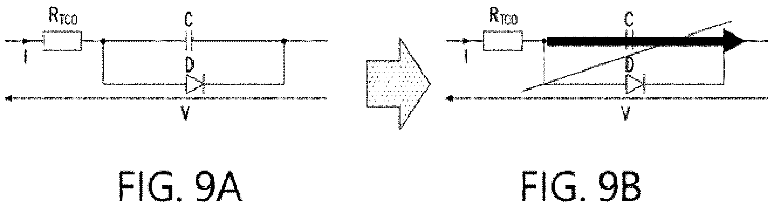

FIG. 9A is an equivalent circuit diagram of an organic light emitting element in an embodiment of the disclosure. With reference to FIG. 9A, the equivalent circuit of the organic light emitting element includes a capacitor C, an equivalent diode D and a resistance $R_{TCO}$ of a transparent conductive layer. A resistance of the organic light emitting element is determined by the resistance $R_{TCO}$ of the transparent conductive layer, and relates to an area of the transparent conductive layer. As shown in FIG. 9A, a voltage V and a current I are provided to drive the organic light emitting element.

FIG. 9B is an equivalent circuit diagram of an organic light emitting element in short-circuit state in an embodiment of the disclosure. With reference to FIG. 9B, when the organic light emitting element is in short-circuit state, the capacitor C and the equivalent diode D are short-circuited. At that time, the voltage V of the organic light emitting element relates to a size of the resistance $R_{TCO}$ of the transparent conductive layer and a magnitude of the current I of the organic light emitting element (which may be learnt according to the formula V=IR). Since the resistance $R_{TCO}$ of the transparent conductive layer is ready a fixed parameter for various organic light emitting elements (with different area sizes), a voltage for short-circuit detection may be set by controlling the magnitude of the current I provided to the organic light emitting element.

[Embodiment of short-circuit protection]

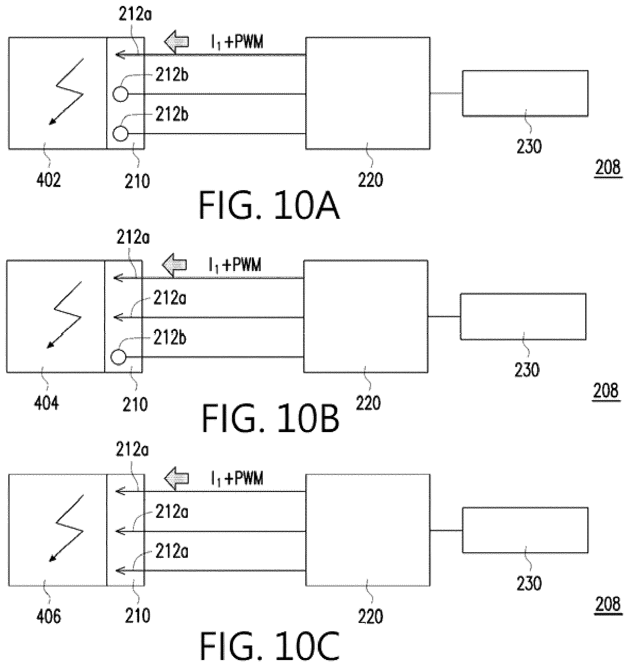

FIG. 10A to FIG. 10C are schematic diagrams respectively illustrating first to third organic light emitting elements in short-circuit state driven by a driving module in an embodiment of the disclosure. With reference to FIG. 10A to FIG. 10C, in a driving module 208 of this embodiment, the multi-channel driver 220 provides a short-circuit detection current $I_1$+PWM transmitted to first to third organic light emitting elements 402 to 406 to obtain a short-circuit detection voltage. A maximum value of the short-circuit detection voltage is less than a rated voltage of the multi-channel driver 220, and a minimum value of the short-circuit detection voltage is positively correlated with the area size of the organic light emitting elements 402 to 406.

With reference to FIG. 10A, for example, the rated voltage of the multi-channel driver 220 is 5V, and the resistance $R_{TCO}$ of the transparent conductive layer of the first organic light emitting element 402 (with the small area) is 10Ω; also, the multi-channel driver 220 only utilizes the first electrical channel 212a to provide the short-circuit detection current $I_1$+PWM (50mA). Thus, the short-circuit detection voltage is (50mA x 10Ω) =0.5V, which is less than the rated voltage 5V of the multi-channel driver 220.

With reference to FIG. 10B, for example, the rated voltage of the multi-channel driver 220 is 5V, and the resistance $R_{TCO}$ of the transparent conductive layer of the second organic light emitting element 404 (with the medium area) is 20Ω; also, the multi-channel driver 220 only utilizes the first electrical channel 212a to provide the short-circuit detection current $I_1$+PWM (50mA). Thus, the short-circuit detection voltage is (50mA x 20Ω) =1V, which is less than the rated voltage 5V of the multi-channel driver 220.

With reference to FIG. 10C, for example, the rated voltage of the multi-channel driver 220 is 5V, and the resistance $R_{TCO}$ of the transparent conductive layer of the third organic light emitting element 406 (with the large area) is 30Ω; also, the multi-channel driver 220 only utilizes the first electrical channel 212a to provide the short-circuit detection current $I_1$+PWM (e.g., 50mA). Thus, the short-circuit detection voltage is (50mA x 30Ω) =1.5V, which is less than the rated voltage 5V of the multi-channel driver 220.

In other words, in a short-circuit mode, because the multi-channel driver 220 utilizes only the first electrical channel 212a to provide the short-circuit detection current $I_1$+PWM transmitted to the first to the third organic light emitting elements 402 to 406, values for setting a determination voltage value may be expressed by Formula (1) below.

$$1.5V < \text{the determination voltage value} < 5V \qquad \text{Formula (1)}$$

wherein 1.5V is the short-circuit detection voltage of the third organic light emitting element 406, and 5V is the rated voltage of the multi-channel driver 220.

In this way, whether the first to the third organic light emitting elements 402 to 406 are short-circuited may be determined for the short-circuit protection.

In another embodiment, when the multi-channel driver 220 is a programmable multi-channel driver, an output current may be set for each channel of the programmable multi-channel driver. When the multi-channel driver 220 adopts the programmable multi-channel driver, the short-circuit detection current $I_1$+PWM may be set smaller (e.g., 10mA). In this case, the short-circuit detection voltage of the first organic light emitting element 402 shown in FIG. 10A is (10mA x 10Ω) = 0.1V; the short-circuit detection voltage of the second organic light emitting element 404 shown in FIG. 10B is (10mA x 20Ω) = 0.2V; the short-circuit detection voltage of the third organic light emitting element 406 shown in FIG. 10C is (10mA x 30Ω) = 0.3V, and thus the values for setting the determination voltage value may be expressed by Formula (2) below.

$$0.3V < \text{the determination voltage value} < 5V \qquad \text{Formula (2)}$$

wherein 0.3V is the short-circuit detection voltage of the third organic light emitting element 406, and 5V is the rated voltage of the multi-channel driver 220.

In this way, whether the first to the third organic light emitting elements 402 to 406 are short-circuited may be determined more effectively for the short-circuit protection.

[Embodiment of driving method]

The driving method in this embodiment of the disclosure may be comprehended with reference to FIG. 3A and FIG. 3C. The driving method is used to drive at least one of the organic light emitting elements 102 to 106. The driving method includes: providing the driving interface 210, which is electrically connected to the organic light emitting elements 102 to 106, wherein the driving interface 210 has a plurality of electrical channels 212a to 212b, where these electrical channels 212a to 212b may selectively be in a connecting state or a floating state; and providing the multi-channel driver 220, which is electrically connected to the driving interface 210, wherein the multi-channel driver 220 transmits a constant current signal ($I_1$+PWM, $I_2$+PWM, $I_3$+PWM) to the driving interface210; Here, the multi-channel driver 220 detects whether the driving interface 210 includes the electrical channel 212b in the floating state. If the electrical channel 212b in the floating state is included, the multi-channel driver 220 provides the constant current signal to the electrical channel 212a in the connecting state. If the electrical channel 212b in the floating state is not included, the constant current signal is provided to each of the electrical channels 212a, and a total current value output by the driving interface 210 is positively correlated with an area size of each of the organic light emitting elements 102 to 104 being the load.

Embodiments regarding elements of the driving module used in the driving method have been described above, which are not repeated hereinafter.

[Embodiment of light emitting element having driving interface]

In another embodiment of the disclosure, a light emitting element is provided and includes the driving interface 210. The driving interface 210 has a plurality of electrical channels 212, wherein the electrical channels 212 are selectively to be in a floating state or a connecting state according to an area size and an efficiency level of the light emitting element (referring to FIGs. 3A to FIG. 3C). In an embodiment, the light emitting element is an organic light emitting element 100.

In an embodiment, the electrical channels are able to contain only one cathode channel (i.e., the cathode 362, referring to FIG. 8C), or contain only one anode channel (i.e., the anode 344, referring to FIG. 7C). In an embodiment, the electrical channels contain the cathode channel (i.e., the cathode 352) and the anode channel (i.e., the anode 354), wherein a distribution of the electrical channels is a symmetrical distribution (referring to FIG. 7D).

In summary, according to the driving module of the light emitting element and the driving method of the disclosure, the driving interface and the multi-channel driver are provided. When the light emitting elements of different types are connected, the driving current required by the light emitting elements may be automatically provided so not only is it not necessary to set the set resistor, the window resistor, etc. on the light emitting element in advance, it is not necessary to change the value of the driving current by utilizing manual switches either.

Furthermore, the driving module of the light emitting element and the driving method of the disclosure can automatically perform the short-circuit detection on the light emitting element for the short-circuit protection.

## Claims

1. A driving module (200, 202, 204, 206, 208) for driving at least one light emitting element (100, 102, 104, 106, 402, 404, 406), the driving module (200, 202, 204, 206, 208) comprising:

   a driving interface (210, 300, 310, 320, 330, 340, 350, 360, 370), electrically connected to the light emitting element (100, 102, 104, 106, 402, 404, 406), the driving interface (210, 300, 310, 320, 330, 340, 350, 360, 370) having a plurality of electrical channels (212, 212a, 212b, 342, 344, 352, 354, 362, 364, 372, 374), wherein the electrical channels (212, 212a, 212b, 342, 344, 352, 354, 362, 364, 372, 374) are selectively to be in a floating state or a connecting state; and
   a multi-channel driver (220), electrically connected to the driving interface (210, 300, 310, 320, 330, 340, 350, 360, 370), the multi-channel driver (220) transmitting a constant current signal ($I_1$+PWM, $I_2$+PWM, $I_3$+PWM) to the driving interface (210, 300, 310, 320, 330, 340, 350, 360, 370),
   wherein the constant current signal ($I_1$+PWM, $I_2$+PWM, $I_3$+PWM) enters the light emitting element (100, 102, 104, 106, 402, 404, 406) through the electrical channel (212, 212a, 212b, 342, 344, 352, 354, 362, 364, 372, 374) in the connecting state, and
   a total current value output by the driving interface (210, 300, 310, 320, 330, 340, 350, 360, 370) is positively correlated with an area size of the light emitting element (100, 102, 104, 106, 402, 404, 406) being a load.

2. A driving module (200, 202, 204, 206, 208) for driving at least one light emitting element (100, 102, 104, 106, 402, 404, 406), the driving module (200, 202, 204, 206, 208) comprising:

a driving interface (210, 300, 310, 320, 330, 340, 350, 360, 370), electrically connected to the light emitting element (100, 102, 104, 106, 402, 404, 406), the driving interface (210, 300, 310, 320, 330, 340, 350, 360, 370) having a plurality of electrical channels (212, 212a, 212b, 342, 344, 352, 354, 362, 364, 372, 374), wherein the electrical channels (212, 212a, 212b, 342, 344, 352, 354, 362, 364, 372, 374) are selectively to be in a floating state or a connecting state; and

a multi-channel driver (220), electrically connected to the driving interface (210, 300, 310, 320, 330, 340, 350, 360, 370), the multi-channel driver (220) transmitting a constant current signal ($I_1$+PWM, $I_2$+PWM, $I_3$+PWM) to the driving interface (210, 300, 310, 320, 330, 340, 350, 360, 370),

wherein the constant current signal ($I_1$+PWM, $I_2$+PWM, $I_3$+PWM) enters the light emitting element (100, 102, 104, 106, 402, 404, 406) through the electrical channel (212, 212a, 212b, 342, 344, 352, 354, 362, 364, 372, 374) in the connecting state, and

a total current value output by the driving interface (210, 300, 310, 320, 330, 340, 350, 360, 370) is negatively correlated with an efficiency of the light emitting element (100, 102, 104, 106, 402, 404, 406) being a load.

3. The driving module (200, 202, 204, 206, 208) of claim 1 or claim 2, further comprising:

a controller (230), electrically connected to the multi-channel driver (220),
the controller (230) controlling the constant current signal ($I_1$+PWM, $I_2$+PWM, $I_3$+PWM) output by the multi-channel driver (220).

4. The driving module (200, 202, 204, 206, 208) of claim 1 or claim 2, wherein the constant current signal comprises:
a plurality of pulse amplitude modulating signals (PAM, $I_1$, $I_1$+$I_2$, $I_1$+$I_2$+$I_3$) having different sizes and superimposing with each other.

5. The driving module (200, 202, 204, 206, 208) of claim 1 or claim 2 , wherein the constant current signal comprises:
a plurality of pulse amplitude modulating signals (PAM, $I_1$, $I_1$+$I_2$, $I_1$+$I_2$+$I_3$) having different sizes and superimposing with each other, and a pulse width modulation signal (PWM) having a settable duty ratio.

6. The driving module (200, 202, 204, 206, 208) of claim 1 or claim 2, further comprising:

a reference resistor ($R_{IREF}$), connected to the multi-channel driver (220),
the multi-channel driver (220) utilizing the reference resistor ($R_{IREF}$) to set a maximum output current value of the multi-channel driver (220).

7. The driving module (200, 202, 204, 206, 208) of claim 1 or claim 2, wherein
the multi-channel driver (220) provides a short-circuit detection current ($I_1$+PWM) transmitted to the light emitting element (402, 404, 406) to obtain a short-circuit detection voltage,
a maximum value of the short-circuit detection voltage is less than a rated voltage of the multi-channel driver (220), and
a minimum value of the short-circuit detection voltage is positively correlated with the area size of the light emitting element (402, 404, 406).

8. The driving module (200, 202, 204, 206, 208) of claim 1 or claim 2 , wherein
the multi-channel driver (220) is a programmable multi-channel driver capable of setting an output current for each channel of the programmable multi-channel driver (220).

9. The driving module (200, 202, 204, 206, 208) of claim 1 or claim 2, wherein the multi-channel driver (220) comprises:
a plurality of channels, each of the channels outputting the same constant current signal.

10. The driving module (200, 202, 204, 206, 208) of claim 1 or claim 2, wherein the multi-channel driver (220) comprises:
a plurality of channels, a set number of the channels in parallel with each other being used as a group, the channels in the group outputting the same constant current signal.

11. The driving module (200, 202, 204, 206, 208) of claim 1 or claim 2, wherein
the electrical channels are able to contain only one cathode channel (362) or contain only one anode channel (344).

12. The driving module (200, 202, 204, 206, 208) of claim 1 or claim 2, wherein
the electrical channels comprise a cathode channel (352, 372) and an anode channel (354, 374), and
a distribution of the electrical channels is a symmetrical distribution.

13. A organic light emitting element (100, 102, 104, 106, 402, 404, 406), comprising:

a driving interface (210, 300, 310, 320, 330, 340, 350, 360, 370), having a plurality of electrical channels (212, 212a, 212b, 342, 344, 352, 354, 362, 364, 372, 374),
wherein the electrical channels (212, 212a, 212b, 342, 344, 352, 354, 362, 364, 372, 374) are selectively to be in a floating state or a connecting state according to an area size or an efficiency level of the light emitting element (100, 102, 104, 106, 402, 404, 406).

14. The light emitting element (100, 102, 104, 106, 402, 404, 406) of claim 13, wherein the electrical channels are able to contain only one cathode channel (362) or contain only one anode channel (344).

15. The light emitting element (100, 102, 104, 106, 402, 404, 406) of claim 13 or claim 14, wherein the electrical channels comprise a cathode channel (352, 372) and an anode channel (354, 374), and a distribution of the electrical channels is a symmetrical distribution.

FIG. 1A

FIG. 1B

PAM

$I_1+I_2+I_3$

$I_1+I_2$

$I_1$

Time

FIG. 2A

PAM+PWM

$I_1+I_2+I_3$

$I_1+I_2$

$I_1$

Time

FIG. 2B

EP 3 405 007 A1

FIG. 3A

FIG. 3B

FIG. 3C

EP 3 405 007 A1

FIG. 4A

FIG. 4B

EP 3 405 007 A1

EP 3 405 007 A1

212a

OLED+

OLED−

$I_1$+PWM

$I_2$+PWM

$I_3$+PWM

$V_{IN}$

$V_{IREF}$

230

206

100 212b 210 220

## FIG. 5A

212a

OLED+

OLED−

$I_1$+PWM

$I_2$+PWM

$I_3$+PWM

$V_{IN}$

$V_{IREF}$

230

206

100 212b 210 220

## FIG. 5B

FIG. 6A

FIG. 6B

FIG. 6C

FIG. 7A

FIG. 7B

FIG. 7C

FIG. 7D

EP 3 405 007 A1

EP 3 405 007 A1

OLED

324
}322

100    320

**FIG. 8A**

OLED

334
}332
334

100    330

**FIG. 8B**

OLED

364
362

100    360

**FIG. 8C**

OLED

374
372

100    370

**FIG. 8D**

FIG. 9A

FIG. 9B

FIG. 10A

FIG. 10B

FIG. 10C

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2002/105373 A1 (SUDO MINORU [JP])<br>8 August 2002 (2002-08-08)<br>* paragraphs [0004], [0006], [0030] - [0033]; figures 1,2,15 *<br>----- | 1-12<br><br>13-15 | INV.<br>H05B33/08<br>F21V23/06<br><br>ADD.<br>H01L51/52<br>H01L27/32 |
| X<br><br>A | US 2015/115237 A1 (DIEKMANN KARSTEN [DE] ET AL) 30 April 2015 (2015-04-30)<br>* paragraphs [0029], [0071], [0074], [0085], [0108]; figures 1, 3, 6 *<br>----- | 13-15<br><br>1-12 | |

TECHNICAL FIELDS
SEARCHED       (IPC)

H05B
H01L
F21V

The present search report has been drawn up for all claims

| Place of search | Date of completion of the search | Examiner |
|---|---|---|
| Munich | 5 October 2018 | Erskine, Andrew |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...................................................................
& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 18 17 2713

This annex lists the patent family members relating to the patent documents cited in the above-mentioned European search report.
The members are as contained in the European Patent Office EDP file on
The European Patent Office is in no way liable for these particulars which are merely given for the purpose of information.

05-10-2018

| Patent document cited in search report | | | Publication date | Patent family member(s) | | | Publication date |
|---|---|---|---|---|---|---|---|
| US 2002105373 | A1 | | 08-08-2002 | CN | 1370035 | A | 18-09-2002 |
| | | | | JP | 3957150 | B2 | 15-08-2007 |
| | | | | JP | 2002319707 | A | 31-10-2002 |
| | | | | KR | 20020066216 | A | 14-08-2002 |
| | | | | KR | 20080034864 | A | 22-04-2008 |
| | | | | TW | I274426 | B | 21-02-2007 |
| | | | | US | 2002105373 | A1 | 08-08-2002 |
| US 2015115237 | A1 | | 30-04-2015 | CN | 104012188 | A | 27-08-2014 |
| | | | | DE | 102011056570 | A1 | 20-06-2013 |
| | | | | KR | 20140107476 | A | 04-09-2014 |
| | | | | KR | 20160058192 | A | 24-05-2016 |
| | | | | US | 2015115237 | A1 | 30-04-2015 |
| | | | | WO | 2013087745 | A1 | 20-06-2013 |

EPO FORM P0459

For more details about this annex : see Official Journal of the European Patent Office, No. 12/82